# EUROPEAN PATENT APPLICATION

(11) **EP 3 805 791 A1**
(43) Date of publication of application: **14.04.2021**
(21) Application number: 19201925.5
(22) Date of filing: 08.10.2019
(51) Int. Cl.: G01S 7/4861, G01S 7/487, G01S 17/10, H03F 3/08

(54) **OPTICAL RECEIVER SYSTEM AND METHOD FOR OPERATING AN OPTICAL RECEIVER SYSTEM, PARTICULARLY OF A LIGHT DETECTION AND RANGING SYSTEM**

(71) Applicant: Integrated Device Technology, Inc., San Jose CA 95138 (US)
(72) Inventor: TAVANO, Giuseppe, 80992 München (DE); SCHIAPPELLI, Fulvio, 81479 München (DE)
(74) Representative: Lippert Stachow Patentanwälte Rechtsanwälte Partnerschaft mbB

(57) **Abstract**

The invention relates to an optical receiver system (1) and method for operating the same, particularly of a light detection and ranging system, comprising:
an optical receiver (2) for receiving a light signal (3) from the surroundings of the optical receiver system (1),
a resistor-capacitor filter 4 connected to the optical receiver 2, and
a transimpedance amplifier 7 for amplifying the filtered signal of the optical receiver (2) comprising a feedback resistor (9),
which is characterized by
a clipping detector (10) connected to the output of the transimpedance amplifier (7) and a first switch (11) operated by the clipping detector (10) and arranged in parallel to the feedback resistor (9) of the transimpedance amplifier (7), wherein the clipping detector (10) can detect a clipping of the output of the transimpedance amplifier (7) and in case of clipping closes the first switch (11) for a predefined time.

## Description

The invention relates to an optical receiver system, particularly of a light detection and ranging system. The invention further relates to a method for operating an optical receiver system, particularly of a light detection and ranging system.

Optical receiver systems are for example used in light detection and ranging (Lidar) systems, also called laser detection and ranging (Ladar) systems. Such systems measure the distance to a target by illuminating the target with pulsed laser light and measuring the reflected pulses with an optical sensor. Differences in laser return times and wavelength can then be used to make 3-D representations of the target. Lidar systems have become popular in automotive applications, for example in advanced safety systems. A lidar systems is for example used to scan the surroundings of a car to detect any obstacles on a collision course with the car and issue a warning to the driver and/or to initiate an emergency brake. Lidar systems are often used in autonomous cars for controlling and navigation purposes. In such automotive applications it is essential that the Lidar systems is highly available and precise with a minimum of detection errors.

The optical receiver system usually comprises or is connected to a string of optical receivers, which are for example arranged in the front part of an automobile. For example, the optical receiver system is arranged inside the automobile and connected to the string of optical receivers via a cable. The optical receiver system comprises at least one optical receiver channel, which is connectable to a respective optical receiver. Usually the optical receiver system comprises a separate optical receiver channel for each optical receiver.

The optical receiver system amplifies the signal of the optical receiver before processing the optical receiver signal. The amplified optical receiver signal is usually converted from the analog domain to the digital domain by an analog-to-digital converter and afterwards being processed by a digital signal processor. Therefore, each optical receiver channel comprises a separate amplifier system for amplifying the respective optical receiver signals.

The amplifier of the optical receiver system, particularly of the optical receiver channel, is a transimpedance amplifier. Commonly used transimpedance amplifiers comprise an operational amplifier and a feedback resistor.

Furthermore, the input of the optical receiver channel comprises or is connected to a filter for suppressing DC signal parts, e.g. to reduce the impact of the daylight on the signal of the optical receiver. Usually, the filter is a resistor-capacitor filter. The filter is arranged between the optical receiver and the amplifier of the optical receiver system.

The received light signals from the surroundings of the light detection and ranging system have a wide dynamic range because the expansion of the light sent out to the target is damped more and more for far objects (1/r²). Furthermore, the reflectivity of the object and/or the light scattered from the object can vary in a wide range. Another factor for the received signal strength is the sensitivity of the photo detector used in the optical receiver. The dynamic range in the receive signal path is an important feature of the optical receiver system of the Lidar system because if the gain of the amplifier is too low strong signals can be detected but weak signals cannot be detected properly. If the gain of the amplifier is too high strong signals cannot be detected properly but weak signals can be detected properly.

A strong signal can cause the transimpedance amplifier to go to saturation, which results in a clipping of the output of the transimpedance amplifier to zero or to supply depending on the current direction and, then, the photodiode type. If a PIN photodiode is used, the current is sourced to the amplifier. If an APD photodiode is used the current is sinked from the amplifier. In case of a PIN photodiode for example, if a clipping event happens, the feedback loop of the transimpedance amplifier is broken, causing a dramatic change in the input impedance of the transimpedance amplifier, which will be more or less equivalent to the resistance of the feedback resistor of the transimpedance amplifier. The transimpedance amplifier recovers from the saturation since a current flows from the feedback resistor of the transimpedance amplifier via the resistor-capacitor filter to ground, i.e. the current flows in the opposite direction as in the usual operating condition. The recovery time is defined by τ = (R_{feedback} + R_{filter}) ^{∗} C_{filter}. Since the feedback resistor R_{feedback} is usually high compared to the filter resistor R_{filter}, the recovery time is mainly influenced by the feedback resistor R_{feedback}.

During the recovery time no signals of the surroundings of the light detection and ranging system can be processed by the optical receiver system.

It is therefore an object of the present invention to provide an optical receiver system, particularly of a light detection and ranging system, that has a minimum recovery time in case of a saturated transimpedance amplifier.

The object is solved by an optical receiver system, particularly of a light detection and ranging system, comprising:
an optical receiver for receiving a light signal from the surroundings of the optical receiver system and providing an analog electrical signal as a function of the received light signal,
a resistor-capacitor filter connected to the optical receiver, and
a transimpedance amplifier for amplifying the filtered signal of the optical receiver, wherein the transimpedance amplifier comprises an operational amplifier and a feedback resistor,
characterized in that
the optical receiver system further comprises a clipping detector connected to the output of the transimpedance amplifier and a first switch operated by the clipping detector and arranged in parallel to the feedback resistor of the transimpedance amplifier, wherein the clipping detector can detect a clipping of the output of the transimpedance amplifier and in case of clipping of the output of the transimpedance amplifier closes the first switch for a predefined time.

The optical receiver system refers to a common optical receiver system comprising an optical receiver, a filter for the signal of the optical receiver and an amplifier for the filtered signal. The optical receiver can be built integrally in the optical receiver system or connected to the optical receiver system. The optical receiver system can further comprise an analog-to-digital converter for converting the amplified signal from the analog domain to the digital domain for further processing, e.g. by a digital signal processor. The optical receiver system can comprise or be connected to multiple optical receivers, wherein the optical receiver system comprises a separate optical receiver channel for each optical receiver. Each optical receiver channel comprises a filter and an amplifier for the filtered signal. Furthermore, the signals of multiple optical receivers are filtered by separate filters. The characteristics of the separate filters are preferably matched to the characteristics of the corresponding optical receiver.

According to the invention the optical receiver system, respectively each optical receiver channel in case of multiple optical receivers, comprises a clipping detector. The clipping detector detects a clipping of the output of the transimpedance amplifier, i.e. a saturation of the transimpedance amplifier. To reduce the recovery time of the transimpedance amplifier the clipping detector closes the first switch arranged in parallel to the feedback resistor of the transimpedance amplifier. Thus, the feedback resistor of the transimpedance amplifier is short-cut by the first switch and the recovery time of the transimpedance time is defined by the resistor of the resistor-capacitor filter only, which is usually smaller than the feedback resistor of the transimpedance amplifier. The clipping detector closes the first switch for a predefined time, which corresponds to the time necessary for recovery of the transimpedance amplifier. Thus, the predefined time can be calculated by τ = R_{filter} ^{∗} C_{filter}. After the transimpedance amplifier has recovered and the first switch is opened again after the predefined time, the optical receiver system is in a normal operating condition again and can processed light signals received from the surroundings properly.

In a preferred variant of the invention the feedback resistor is larger than the resistor of the resistor-capacitor filter, at least twice as large as the resistor of the resistor-capacitor filter. Since the recovery time of the transimpedance amplifier is directly proportional to the resistance of the resistor of the resistor-capacitor filter and the feedback resistor is short-cut by the first switch in case of clipping of the output of the transimpedance amplifier, i.e. during saturation, it is advantageous if the feedback resistor is larger than the resistor of the resistor-capacitor filter.

Pursuant to a variant of the invention the input impedance of the transimpedance amplifier is smaller than the resistor of the resistor-capacitor filter, at least half of the resistor of the resistor-capacitor filter. The input impedance, represented by the equivalent resistor of the transimpedance amplifier, is preferably much smaller than the resistor of the resistor-capacitor filter because this minimizes the negative effect of the resistor of the resistor-capacitor filter, which is generally arranged in parallel to the input of the transimpedance amplifier.

According to a variant of the invention the clipping detector comprises or is connected to a pulse generator, wherein the pulse generator operates the first switch. Thus, the switch is for example closed if the pulse generator generates a pulse. In this case the width of the generated pulse corresponds to the predefined time. Since the pulse generator can easily adapt the pulse-width, the optical receiver system can be adapted to different recovery times by simply changing the generated pulse-width. Hence, in a variant of the invention the pulse generator generates pulse with a pulse-width corresponding to the predefined time.

In an advantageous variant of the invention the optical receiver system further comprises a second switch arranged in parallel to the resistor of the resistor-capacitor filter, wherein the second switch is operated together with the first switch. Thus, also the resistor of the resistor-capacitor filter is shortcut in case of a clipping of the output of the transimpedance amplifier, i.e. saturation of the transimpedance amplifier. The recovery time of the transimpedance amplifier in this case only depends on the capacitor of the resistor-capacitor filter. This further reduces the recovery time of the transimpedance amplifier, which is even faster back in a normal operating condition.

The optical receiver system can further comprise an analog-to-digital converted for the amplified signal and/or a signal processing unit for processing the amplified and eventually converted signal.

According to the invention the object is further solved by a method for operating an optical receiver system, particularly of a light detection and ranging system, comprising the steps of:
creating an analog electrical signal by an optical receiver of the optical receiver system corresponding to a received light signal from the surroundings of the optical receiver system,
filtering the created analog electrical signal by a resistor-capacitor filter,
amplifying the filtered signal of the optical receiver by a transimpedance amplifier comprising an operational amplifier and a feedback resistor,
characterized by
detecting a clipping of the output of the transimpedance amplifier and in case of clipping of the output of the transimpedance amplifier executing the step of short-cutting the feedback resistor of the transimpedance amplifier for a predefined time.

Thus, according to the invention the output of the transimpedance amplifier is monitored and if a clipping of the output of the transimpedance amplifier is detected, i.e. the transimpedance amplifier is saturated, the feedback resistor of the transimpedance amplifier is short-cut for a predefined time to reduce the recovery time of the transimpedance amplifier. The predefined time corresponds to the recovery time of the transimpedance amplifier.

Pursuant to a preferred variant of the invention the method comprises the step of generating a pulse for closing a switch for short-cutting the feedback resistor of the transimpedance amplifier. The generation of a pulse has the advantage that the length of the pulse, i.e. the predefined time, can be easily adapted to different recovery times. Preferably the pulse-width of the generated pulse corresponds to the predefined time.

In a preferred variant of the invention the method comprises the further step of short-cutting the resistor of the resistor-capacitor filter together with the short-cutting of the feedback resistor of the transimpedance amplifier. This further reduces the recovery time of the transimpedance amplifier, which in this case mainly depends on the capacitor of the resistor-capacitor filter.

The method according to the invention can comprise the further step of converting the amplified signal from the analog domain to the digital and/or the step of further processing the amplified and eventually converted signal, e.g. for object detection in a light detection and ranging system.

In the following the invention will be further explained with respect to the embodiments shown in the figures. It shows:
- Fig. 1: a block diagram of a first embodiment of an optical receiver system according to the invention, and
- Fig. 2: a block diagram of a second embodiment of an optical receiver system according to the invention.

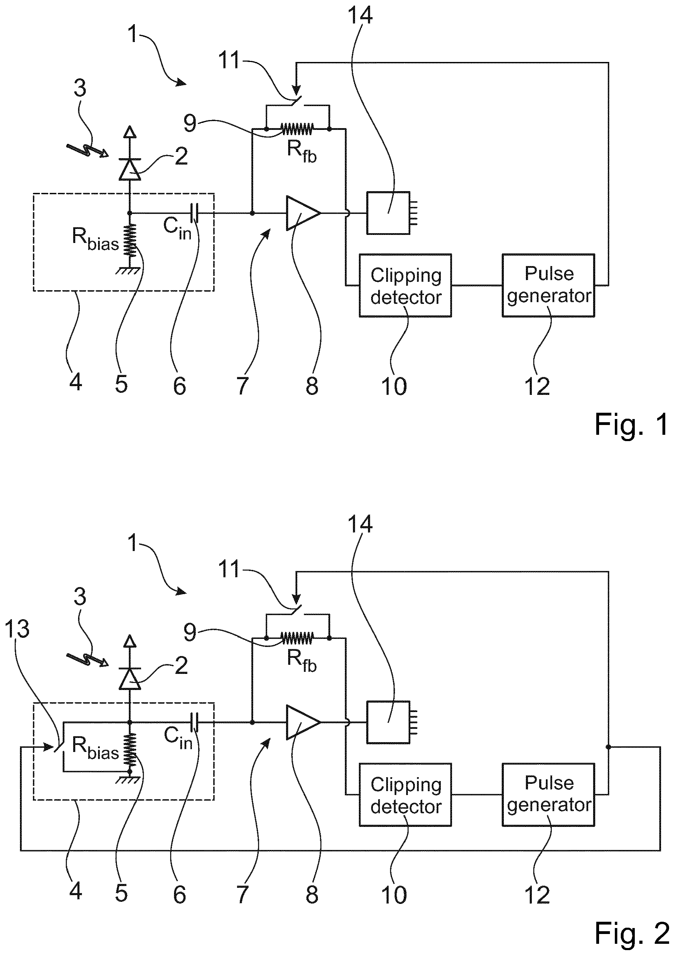

Fig. 1 shows a block diagram of a first embodiment of an optical receiver system 1, particularly of a light detection and ranging system, according to the invention. The optical receiver system 1 comprises an optical receiver 2 for receiving a light signal 3 from the surroundings of the optical receiver system 1 and providing an analog electrical signal as a function of the received light signal 3. For example, the optical receiver is a photo detector like a photodiode.

The optical receiver system further comprises a resistor-capacitor filter 4 connected to the optical receiver 2. The resistor-capacitor filter 4 comprises a resistor 5 that is connected to ground and the output of the optical receiver 2. The capacitor 6 of the resistor-capacitor filter 4 is like the resistor 5 also connected to the output of the optical receiver 2 and further to a transimpedance amplifier 7 of the optical receiver system 1. Due to the filter 4 only AC signals are further processed and any DC signal components are suppressed. DC signal components are for example caused by the daylight impact on the optical receiver.

The transimpedance amplifier 7 amplifies the filtered signal of the optical receiver 2. The transimpedance amplifier comprises an operational amplifier 8 and a feedback resistor 9.

According to the invention the optical receiver system 1 further comprises a clipping detector 10 connected to the output of the transimpedance amplifier 7 and a first switch 11 operated by the clipping detector 10 and arranged in parallel to the feedback resistor 9 of the transimpedance amplifier 7. The clipping detector 10 can detect a clipping of the output of the transimpedance amplifier 7 and in case of clipping of the output of the transimpedance amplifier 7 closes the first switch 11 for a predefined time.

Preferably, the feedback resistor 9 is larger than the resistor 5 of the capacitor-resistor filter 4, particularly twice as large as the resistor 5 of the resistor-capacitor filter 4.

Furthermore, the input impedance of the transimpedance amplifier 7 is smaller than the resistor 5 of the resistor-capacitor filter 4, particularly at least half of the resistor 5 of the resistor-capacitor filter 4.

The clipping detector 10 is connected to a pulse generator 12, wherein the pulse generator 12 operates the first switch 11. Preferably, the pulse generator 12 generates a pulse with a pulse-width corresponding to the predefined time and the first switch 11 is closed during this pulse-width.

The optical receiver 2 of the optical receiver system 1 creates an analog electrical signal corresponding to the received light signal 3 from the surroundings of the optical receiver system 1. The created analog signal is filtered by the resistor-capacitor filter 4, to suppress DC components of the created analog electrical signal.

The filtered signal of the optical receiver 2 is amplified by the transimpedance amplifier 7, which comprises the operational amplifier 8 and the feedback resistor 9.

According to the invention a clipping of the output of the transimpedance amplifier 7 is detected, e.g. by clipping detector 10. In case of clipping of the output of the transimpedance amplifier 7 the feedback resistor is short-cut for the predefined time, in which the transimpedance amplifier 7 can recover from saturation causing the clipping of the output of the transimpedance amplifier 7.

The amplified signal at the output of the transimpedance amplifier 7 is for example converted by an analog-to-digital converter 14 from the analog domain to the digital domain for further processing, e.g. by a digital signal processor.

Fig. 2 shows a block diagram of a second embodiment of an optical receiver system 1, particularly of a light detection and ranging system, according to the invention. The second embodiment of Fig. 2 differs from the first embodiment of Fig. 1 in that the optical receiver system 1 further comprises a second switch 13 in parallel to the resistor 5 of the resistor-capacitor filter 4. The second switch 13 is operated together with the first switch 11. Thus, the resistor 5 of the resistor-capacitor filter 5 is short-cut together with the feedback resistor 9 of the transimpedance amplifier 9. This further accelerates the recovery of the transimpedance amplifier 7 from saturation.

### Optical receiver system and method for operating an optical receiver system, particularly of a light detection and ranging system

### List of reference numerals

- 1: optical receiver system
- 2: optical receiver
- 3: light signal
- 4: resistor-capacitor filter
- 5: resistor (filter)
- 6: capacitor (filter)
- 7: transimpedance amplifier
- 8: operational amplifier
- 9: feedback resistor
- 10: clipping detector
- 11: first switch
- 12: pulse generator
- 13: second switch
- 14: analog-to-digital converter

## Claims

1. Optical receiver system (1), particularly of a light detection and ranging system, comprising:
an optical receiver (2) for receiving a light signal (3) from the surroundings of the optical receiver system (1) and providing an analog electrical signal as a function of the received light signal (3),
a resistor-capacitor filter 4 connected to the optical receiver 2, and
a transimpedance amplifier 7 for amplifying the filtered signal of the optical receiver (2), wherein the transimpedance amplifier (7) comprises an operational amplifier 8 and a feedback resistor (9),
**characterized in that**
the optical receiver system (1) further comprises a clipping detector (10) connected to the output of the transimpedance amplifier (7) and a first switch (11) operated by the clipping detector (10) and arranged in parallel to the feedback resistor (9) of the transimpedance amplifier (7), wherein the clipping detector (10) can detect a clipping of the output of the transimpedance amplifier (7) and in case of clipping of the output of the transimpedance amplifier (7) closes the first switch (11) for a predefined time.

2. Optical receiver system (1) according to claim 1,
wherein the feedback resistor (9) is larger than the resistor (5) of the resistor-capacitor filter (4), particularly at least twice as large as the resistor (5) of the resistor-capacitor filter (4).

3. Optical receiver system (1) according to claim 1 or claim 2,
wherein the input impedance of the transimpedance amplifier (7) is smaller than the resistor (5) of the resistor-capacitor filter (4), particularly at least half of the resistor (5) of the resistor-capacitor filter (4).

4. Optical receiver system (1) according to any of claims 1 to 3,
wherein the clipping detector (10) comprises or is connected to a pulse generator (12), wherein the pulse generator (12) operates the first switch (11).

5. Optical receiver system (1) according to claim 4,
wherein the pulse generator (12) generates a pulse with a pulse-width corresponding to the predefined time.

6. Optical receiver system (1) according to any of claims 1 to 5,
further comprising a second switch (13) in parallel to the resistor (5) of the resistor-capacitor filter (4), wherein the second switch (13) is operated together with the first switch (11).

7. Method for operating an optical receiver system (1), particularly of a light detection and ranging system, comprising the steps of:
creating an analog electrical signal by an optical receiver (2) of the optical receiver system (1) corresponding to a received light signal (3) from the surroundings of the optical receiver system 81),
filtering the created analog electrical signal by a resistor-capacitor filter (4),
amplifying the filtered signal of the optical receiver (2) by a transimpedance amplifier (7) comprising an operational amplifier (8) and a feedback resistor (9),
**characterized by**
detecting a clipping of the output of the transimpedance amplifier (7) and in case of clipping of the output of the transimpedance amplifier (7) executing the step of short-cutting the feedback resistor (9) for a predefined time.

8. Method according to claim 7,
further comprising the step of generating a pulse for closing a first switch (11) for short-cutting the feedback resistor (9).

9. Method according to claim 8,
wherein the pulse-width of the generated pulse corresponds to the predefined time.

10. Method according to any of claims 7 to 9,
further comprising the step of short-cutting the resistor (5) of the resistor-capacitor filter (4) together with the short-cutting of the feedback resistor (9).
